# EUROPEAN PATENT APPLICATION

(11) **EP 4 502 632 A1**
(43) Date of publication of application: **05.02.2025**
(21) Application number: 22936645.5
(22) Date of filing: 25.11.2022
(51) Int. Cl.: G01R 31/367, G01R 31/392, G01R 31/382, G01R 31/36

(54) **BATTERY MANAGEMENT DEVICE AND METHOD**

(30) Priority: 05.04.2022 KR 20220042555
(71) Applicant: LG Energy Solution, Ltd., Seoul 07335 (KR)
(72) Inventor: KIM, Joo Sung, Daejeon 34122 (KR); KIM, Kang San, Daejeon 34122 (KR); EOM, Jin Uk, Daejeon 34122 (KR); KIM, Geum Bee, Daejeon 34122 (KR)
(74) Representative: Plasseraud IP
(86) International application number: PCT/KR2022/018840
(87) International publication number: WO 2023/195592

(57) **Abstract**

A battery management apparatus according to an aspect of the present disclosure includes a data obtaining unit configured to obtain battery information of at least one of voltage, current, and temperature and a controller configured to determine a data distribution of the battery based on the obtained battery information, determine a matching probability between a plurality of previously obtained target experiment data and the data distribution, determine a score for each of the plurality of target experiment data based on the battery information, and calculate the matching probability corresponding to the score for each of the plurality of target experiment data to calculate a stress score for the battery.

## Description

### [TECHNICAL FIELD]

### CROSS-REFERENCE TO RELATED APPLICATION

This application claims priority to and the benefit of Korean Patent Application No. 10-2022-0042555 filed in the Korean Intellectual Property Office on April 5, 2022, the entire contents of which are incorporated herein by reference.

### TECHNICAL FIELD

The present disclosure relates to a battery management apparatus and method.

### [BACKGROUND ART]

Recently, as the demand for portable electronic products such as laptop computers, video cameras, and mobile phones has increased rapidly, and development of electric vehicles, batteries for energy storage, robots, satellites, etc., has hit its stride, research on high-performance batteries that are repeatedly chargeable and dischargeable is being actively conducted.

Current commercially available batteries include nickel cadmium batteries, nickel hydride batteries, nickel zinc batteries, lithium batteries, and so forth, among which the lithium batteries are in the limelight due to their advantages of free charge and discharge due to little memory effect, very low self-discharge rate, and high energy density, compared to nickel-based batteries.

Much research is being conducted on the batteries in terms of high capacity and high density, but the aspect of improving lifetime and safety is also important. To this end, it is necessary to suppress decomposition with an electrolyte on an electrode surface and prevent over-charge and over-discharge.

To prevent over-charge and over-discharge and improve lifetime and safety of the battery, development of a technique for providing a user with the current state of the battery and a guideline for the same is required.

### [DISCLOSURE]

### [TECHNICAL PROBLEM]

The present disclosure has been made to solve such a problem and aims to score lifetime and safety of a battery and provide them to a user.

Other objects and advantages of the present disclosure may be understood by the following description, and will be more clearly understood by embodiments of the present disclosure. In addition, it would be easily understood that the object and advantages of the disclosure may be implemented by means provided in the claims and a combination thereof.

### [TECHNICAL SOLUTION]

A battery management apparatus according to an aspect of the present disclosure includes a data obtaining unit configured to obtain battery information of at least one of voltage, current, and temperature and a controller configured to determine a data distribution of the battery based on the obtained battery information, determine a matching probability between a plurality of previously obtained target experiment data and the data distribution, determine a score for each of the plurality of target experiment data based on the battery information, and calculate the matching probability corresponding to the score for each of the plurality of target experiment data to calculate a stress score for the battery.

In the battery management apparatus according to an aspect of the present disclosure, the controller may be further configured to determine a type based on whether the obtained battery information is during-driving information or during-charge information and determine the plurality of target experiment data corresponding to the determined type from among a plurality of previously stored experiment data.

In the battery management apparatus according to an aspect of the present disclosure, the controller may be further configured to determine the data distribution of the battery by calculating an area-specific frequency for the battery information.

In the battery management apparatus according to an aspect of the present disclosure, the controller may be further configured to determine the matching probability for each of the plurality of target experiment data based on the area-specific frequency for the battery information and an area-specific frequency for each of the plurality of target experiment data.

In the battery management apparatus according to an aspect of the present disclosure, the controller may be further configured to determine the matching probability based on a similarity between a frequency of each target experiment data and the area-specific frequency for the battery information with respect to a sum of area-specific frequencies of the plurality of target experiment data for each area.

In the battery management apparatus according to an aspect of the present disclosure, the controller may be further configured to sum one or more similarities calculated respectively for the plurality of target experiment data to determine the matching probability corresponding to each of the plurality of target experiment data.

In the battery management apparatus according to an aspect of the present disclosure, the controller may be further configured to determine the score based on a preset experiment condition-specific table for each of the plurality of target experiment data.

In the battery management apparatus according to an aspect of the present disclosure, the experiment condition-specific table may be preset for experiment conditions including at least one of an experiment temperature, a charge current, a discharge current, a maximum (SOC) and a minimum SOC, and an (SOH) corresponding to a number of times of charge/discharge of the target experiment data, and the controller may be further configured to determine the score for a number of times of charge/discharge in which a calculated SOH reaches a threshold value.

In the battery management apparatus according to an aspect of the present disclosure, the controller may be further configured to generate a response message including the stress score and output the generated response message, when receiving a request message for the stress score.

In the battery management apparatus according to an aspect of the present disclosure, the controller may be further configured to further include at least one of a driving guide and a charge guide corresponding to the stress score in the response message.

A battery pack according to an aspect of the present disclosure includes the battery management apparatus according to the aspect of the present disclosure.

A server according to an aspect of the present disclosure includes the battery management apparatus according to the aspect of the present disclosure.

A battery management method according to an aspect of the present disclosure includes obtaining battery information of at least one of voltage, current, and temperature, determining a data distribution of a battery based on the obtained battery information, determining a matching probability between a plurality of previously obtained target experiment data and the data distribution, determining a score for each of the plurality of target experiment data based on the battery information, and calculating a stress score for the battery by calculating the score for each of the plurality of target experiment data and the corresponding matching probability.

### [ADVANTAGEOUS EFFECTS]

According to an aspect of the present disclosure, lifetime and safety of a battery may be scored and provided to a user.

According to another aspect of the present disclosure, in calculation of a stress score of the battery, advanced techniques such as normalization and/or a statistical variable threshold, etc., may be applied to accurately diagnose the lifetime and safety of the battery.

Moreover, according to another aspect of the present disclosure, by analyzing time-series data on a stress score determined based on a statistical variable threshold, it is possible to precisely detect a time point and/or section in which the stress of the battery occurs.

Effects of the present disclosure are not limited to the aforementioned effects, and other unmentioned effects would be apparent to one of ordinary skill in the art from the claims.

### [DESCRIPTION OF DRAWINGS]

The following drawings attached to the present specification serve to further understand the technical spirit of the present disclosure together with the detailed description of the disclosure to be provided later, and thus the present disclosure should not be construed as being limited only to the matters described in the drawings.
FIG. 1 is a view of a battery system according to an embodiment disclosed herein.
FIG. 2 is a block diagram of a battery management apparatus according to an embodiment disclosed herein.
FIG. 3 is a view for describing a method for determining a matching probability referred in various embodiments disclosed herein.
FIG. 4 is a view for describing a method for determining a score for each of a plurality of target experiment data referred in various embodiments disclosed herein.
FIG. 5 is a view for describing a response message referred in various embodiments disclosed herein.
FIG. 6 is another view for describing a response message referred in various embodiments disclosed herein.
FIG. 7 is a diagram schematically showing a battery management method according to an embodiment disclosed herein.
FIG. 8 is a view showing an example configuration of a battery pack including a battery management apparatus according to an embodiment disclosed herein.

### [MODE FOR INVENTION]

Further, terms or words used in the description and claims below should not be interpreted as only general or dictionary meanings, but interpreted as meanings and concepts satisfying the technical spirit of the present disclosure based on a principle in that the inventor can appropriately define his/her disclosure with a concept of the terms in order to describe the disclosure in the best method.

Therefore, since the embodiments described in the present specification and the configurations shown in the drawings are only one of the most preferred embodiments of the present disclosure and do not represent all of the technical spirit of the present disclosure, it should be understood that there may be various equivalents and modifications capable of replacing them at the time of filing of the present disclosure.

When the present disclosure is described, a detailed description of related well-known configurations or techniques will be omitted if it obscures the subject matter of the present disclosure.

Terms including ordinal numbers, such as first, second, etc., are used for the purpose of distinguishing one of various components from the others, and are not used to limit the components by such terms.

Throughout the entirety of the specification of the present disclosure, when it is assumed that a certain part includes a certain component, the term 'including' means that a corresponding component may further include other components unless specially described to the contrary.

In the description of the embodiments of the disclosure, when a part is "connected" to another part, the part is not only "directly connected" to another part but also "indirectly connected" to another part with another device intervening in them.

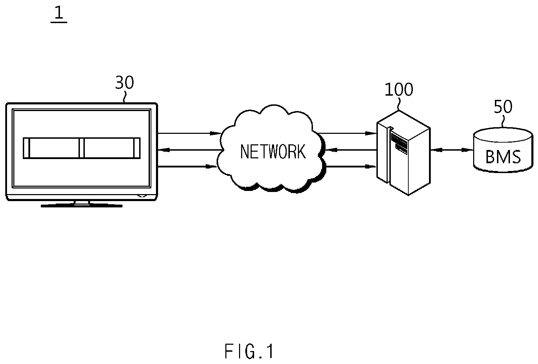

FIG. 1 is a view of a battery system 1 according to an embodiment disclosed herein. Referring to FIG. 1, the battery system 1 may include a battery management apparatus 100. However, this is only a preferred embodiment for achieving the object of the present disclosure, and some components may be added or removed as needed. In addition, it should be noted that respective components of the battery system 1 shown in FIG. 1 represent functionally distinguished functional elements, and a plurality of components may be implemented in a form integrated with each other in an actual physical environment.

In the battery system 1, the battery management apparatus 100 may be a computing device that provides battery management based on stress scores to multiple users. Herein, the computing device may be a laptop, a desktop, a laptop, etc., without being limited thereto, and may include any type of devices including a computing function and a communication function. However, to provide battery management to multiple users, the battery management apparatus 100 may be preferably implemented as a high-performance server computing device.

According to an embodiment, battery management may mean a service provided to a user for lifetime improvement of the battery based on a stress score. Herein, the stress score may refer to a score of effects of an experience and an environment occurring in a charge/discharge situation of a battery included in a vehicle (e.g., a vehicle driving situation and/or a battery charging situation) on the lifetime of the battery.

Generally, a battery cell may include a negative terminal and a positive terminal and mean one independent cell that is physically separable. For example, a lithium ion battery or a lithium polymer battery may be regarded as a battery cell. A plurality of battery cells may be connected in series and/or in parallel to constitute a battery module, and a plurality of battery modules may be connected in series and/or in parallel to constitute a battery pack. A battery for which a stress score may be calculated and provided by the battery management apparatus 100 may be a battery pack included in a vehicle.

According to an embodiment of the present disclosure, the battery management apparatus 100 may receive battery information from a battery management system (BMS) 50 and calculate a stress score for the battery based on the battery information. The battery information may mean data including information of at least one of voltage, current, and temperature of the battery.

According to an embodiment of the present disclosure, the battery management apparatus 100 may calculate a stress score based on a plurality of target experiment data previously obtained.

In the battery system 1, the BMS 50 may lithium-ion be included in the vehicle and transmit information related to the battery included in the battery. More specifically, the BMS 50 may transmit information of at least one of the voltage, the current, and/or the temperature of the battery to the battery management apparatus 100. According to an embodiment, the BMS 50 may transmit information in real time to the battery management apparatus 100, and transmit the information to the battery management apparatus 100 at specific time intervals, without being limited thereto.

The BMS 50 may be set up on a computing device that is physically independent of the battery management apparatus 100, or may be set up on the battery management apparatus 100, which may vary with an embodiment.

According to an embodiment, the battery management apparatus 100 according to the present disclosure may be applied to a BMS. That is, the BMS according to the present disclosure may include the above-described battery management apparatus 100. With this configuration, at least some of components of the battery management apparatus 100 may be implemented by supplementing or adding functions of components included in a conventional BMS. For example, a data obtaining unit 110 and/or a controller 120 of the battery management apparatus 100 described below may be implemented as components of the BMS.

Hereinbelow, a description will continue assuming that the BMS 50 is set up on a computing device that is physically independent of the battery management apparatus 100.

In the battery system 1, a user terminal 30 may be a computing device that transmits a request for a stress score and includes a display for outputting response data including the stress score. Herein, the computing device may be a laptop, a desktop, a laptop, etc., without being limited thereto, and may include any type of devices including a computing function and a communication function. The user terminal 30 may be set up on a computing device that is physically independent of the battery management apparatus 100, or may be set up on the battery management apparatus 100, which may vary with an embodiment. Hereinbelow, a description will continue assuming that the user terminal 30 is set up on a computing device that is physically independent of the battery management apparatus 100.

In an embodiment, the user terminal 30 may display response data in which the stress score is imaged. The battery management apparatus 100 may receive the request for the stress score through a user's terminal and provide the response data including the stress score in response to the received request. In this case, the battery management apparatus 100 may provide a predetermined user interface to the response data to induce a user feedback, and the user may provide user feedback information for a satisfaction with the response data through the interface. The battery management apparatus 100 may reflect the user feedback information to improve the satisfaction of the user in calculation of the stress score.

Components of the battery system 1 may communicate through a network. Herein, the network may be implemented in any type of wired/wireless networks such as a local area network (LAN), a wide area network (WAN), a mobile radio communication network, and Wireless Broadband Internet (Wibro) , etc.

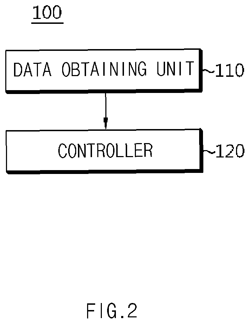

So far, the battery system 1 according to an embodiment of the present disclosure has been described with reference to FIG. 1. Hereinbelow, a configuration and an operation of the battery management apparatus 100 according to an embodiment of the present disclosure will be described with reference to FIGS. 2 to 6.

FIG. 2 is a block diagram of the battery management apparatus 100 according to an embodiment disclosed herein. Referring to FIG. 2, the battery management apparatus 100 according to an embodiment disclosed herein may include the information obtaining unit 110 and the controller 120.

The data obtaining unit 110 may be configured to obtain battery information of at least one of voltage, current, and temperature.

More specifically, the data obtaining unit 110 may obtain information related to a battery for which a stress score is to be calculated. According to an embodiment, the data obtaining unit 110 may obtain, from the BMS 50, the information related to the battery for which a stress score is to be calculated. The information related to the battery may include information related to at least one of voltage, current, and temperature of the battery.

The data obtaining unit 110 may obtain information about the battery from the BMS 50 in real time or according to a predetermined period. Alternatively, the data obtaining unit 110 may obtain the information about the battery from the BMS 50 in case of occurrence of a preset event. The present disclosure is not limited thereto.

When data is not obtained from the BMS 50, the data obtaining unit 110 may transmit a request for providing data to the BMS 50.

The controller 120 may determine a data distribution of the battery based on obtained battery information.

According to an embodiment, the controller 120 may determine the data distribution of the battery by calculating an area-specific frequency for the battery information. Herein, the area-specific frequency may mean an area-specific frequency regarding each battery information.

For example, it is assumed that the voltage is included in the battery information. The controller 120 may divide an area of a battery voltage by predetermined unit (e.g., 0.1 V) in a preset voltage section, and calculate an area-specific frequency to which the battery information belongs in each area. The controller 120 may determine the data distribution of the battery based on the calculated area-specific frequency.

The controller 120 may be configured to determine a matching probability between a plurality of previously obtained target experiment data and a data distribution.

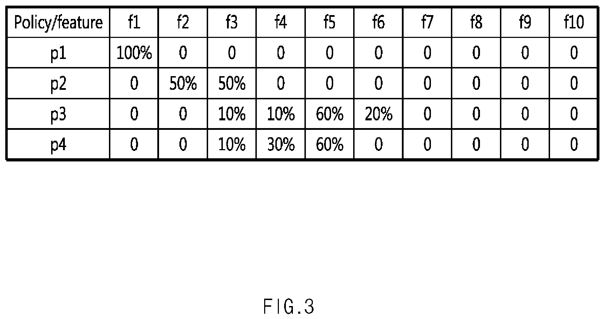

More specifically, the controller 120 may determine the match probability for each of the plurality of target experiment data, based on the area-specific frequency of the battery information and the area-specific frequency of each of the plurality of target experiment data. This will be described in detail with reference to FIG. 3.

FIG. 3 is a view for describing a method for determining a matching probability referred in various embodiments disclosed herein. FIG. 3 shows a table in which a frequency for each area (f1 to f10) for each of a plurality of target experiment data p1 to p4 is shown. Herein, f1 to f10 may mean areas into which the entire area (0 % to 100 %) is proportionally divided by 10 %. For example, f1 may be an area of 0 % or more and below 10 % with respect to the entire area, f2 may be an area of 10 % or more and below 20 % with respect to the entire area, and f10 may be an area of 90 % or more and 100 % or less with respect to the entire area.

Before a description of FIG. 3, it is assumed that the area-specific frequency for the battery information is 10 % for f1, 30 % for f2, and 60 % for f3.

According to an embodiment, the controller 120 may determine the matching probability for each of the plurality of target experiment data p1 to p4 by using the area-specific frequency for the battery information. For example, the area-specific frequency for p1 is 100 % and is 0 % for the other areas. In another example, the area-specific frequency for p2 is 0 % and is 50 %, respectively, for f2 and f3.

According to an embodiment, the controller 120 may determine, for each area, a similarity between a frequency of each target experiment data with respect to a sum of frequencies of a plurality of target experiment data, and a frequency for battery information, and determine a matching probability based on the similarity.

For f1 as an example, the controller 120 may determine a similarity of p1 for f1 by multiplying the frequency for the battery information by "(a frequency of p1 for f1) ÷ (a sum of frequencies of p1 to p4 for f1)".

The sum of the frequencies of the plurality of target experiment data for f1 is 100 + 0 + 0 + 0 and thus is 100, and the frequency of p1 for f1 is 100. The frequency for the battery information is assumed to be 10 %, such that the controller 120 may determine a product of 10 % and (100 ÷ 100) as the similarity of p1 for f1. Thus, the controller 120 may determine the similarity of p1 for f1 as 10 % or 0.1.

In the same manner, the controller 120 may determine similarities of p2 to p4 for f1. Referring to FIG. 3, as the frequencies of p2 to p4 for f1 are 0, the controller 120 may determine the similarities of p2 to p4 for f1 to be 0.

Depending on an embodiment, the controller 120 may sum one or more similarities calculated respectively for the plurality of target experiment data to determine the matching probability corresponding to each of the plurality of target experiment data.

For p1 as an example, the controller 120 may determine a similarity for f1 to be 0.1, and determine similarities for the other areas f2 to f10 as the frequency of p1 for the other areas f2 to f10 is 0.

Thus, by summing the area-specific similarities of p1, the controller 120 may determine 0.1 as a matching probability of p1.

In the same manner, the controller 120 may determine matching probabilities of p2 to p4. Referring to FIG. 3, the controller 120 may determine the matching probabilities of p2 to p4 to be 0.72, 0.09, and 0.09, respectively.

So far, an operation of determining, by the controller 120, determining a matching probability has been described in detail with reference to FIG. 3. The operation of the controller will be described referring back to FIG. 2.

The controller 120 may determine a score for each of the plurality of target experiment data based on the obtained data information.

Depending on an embodiment, the controller 120 may determine a score for each of the plurality of target experiment data based on a preset experiment condition-specific table.

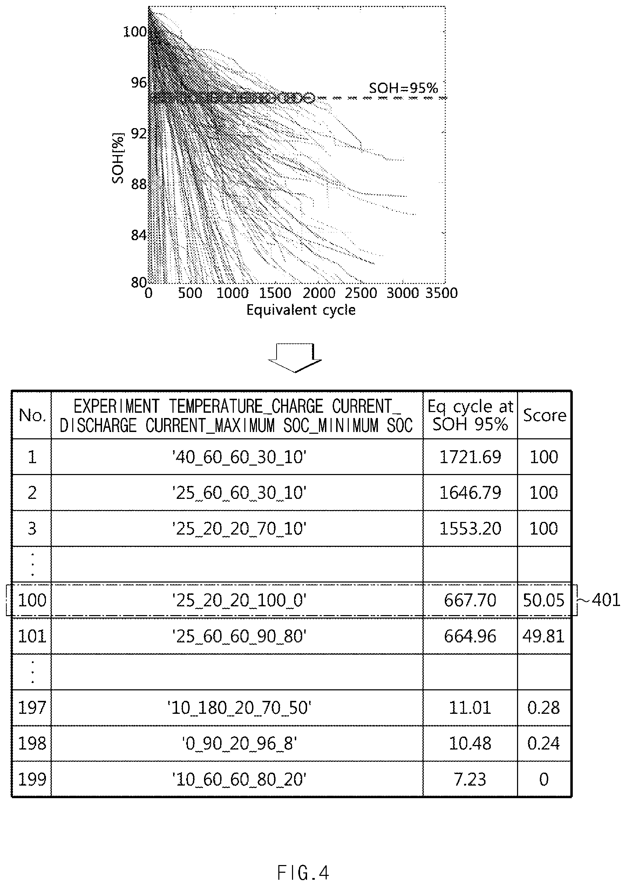

Herein, the preset experiment condition-specific table may mean a table regarding result data of a battery deterioration experiment performed in an environment limited by a specific condition. For example, the experiment condition-specific table may mean a table regarding data of a battery deterioration experiment performed by adding a condition to at least one area among a temperature, a charge current, a discharge current, a minimum SOC, and a maximum SOC of a battery and a SOH with respect to the number times of charge/discharge of the target experiment data. This will be described in detail with reference to FIG. 4.

FIG. 4 is a view for describing a method for determining a score for each of a plurality of target experiment data referred in various embodiments disclosed herein. In FIG. 4 is shown an example diagram where the table is converted into an experiment condition-specific table by using the data obtained from the battery deterioration experiment performed in the limited environment.

Depending on an embodiment, the controller 120 may generate a (SOH) profile according to a cycle by processing data obtained by a battery deterioration experiment performed in the limited environment. The cycle may mean a value obtained by considering charge/discharge of the battery as one period.

For example, 1 cycle may mean that the battery is charged until the (SOC) of the battery becomes 100 % from 0 % and the battery is discharged until the SOC of the battery becomes 0 % from 100 %. That is, 1 cycle may mean that full charge and full discharge are performed on the battery.

In another example, 0.5 cycle may mean that the battery is charged to increase the SOC of the battery by 50 % and the battery is discharged to reduce the SOC of the battery by 50 %. That is, 0.5 cycle may mean that the battery is charged until the SOC of the battery is from a charge start SOC to a charge end SOC and the battery is discharged until the SOC of the battery is from the charge end SOC to the charge start SOC. Herein, an SOC difference between the charge start SOC and the charge end SOC may be 50 %.

Depending on an embodiment, the controller 120 may determine a score for the number of times of charge/discharge in which a calculated SOH reaches a threshold value. The threshold value may be a set value corresponding to the battery or a user-set value. Alternatively, the threshold value may mean a statistical variable value, without being limited thereto.

Depending on an embodiment, the controller 120 may input a cycle value corresponding to a point in which a SOH is a threshold value for each of a plurality of target experiment data, to an experiment condition-specific table. The threshold value may be a value set according to a kind and/or a type of the battery, or may be a value set according to a user's request. Alternatively, the threshold value may be a statistical variable threshold value, without being limited thereto. In FIG. 4, the threshold value is 95 %.

Referring to FIG. 4, the controller 120 may input a cycle value corresponding to a point in which a SOH is 95 % for each of a plurality of target experiment data, to an experiment condition-specific table, by using a SOH profile with respect to a cycle.

The controller 120 may determine a score for each of the plurality of target experiment data based on the input cycle. Depending on an embodiment, the controller 120 may determine a score by interpolating an experiment value for each of the plurality of target experiment data based on standard conditions. For example, when a temperature of the standard conditions is 25 degrees, the controller 120 may determine a score by interpolating a value for a temperature among experiment values of the plurality of respective target experiment data with respect to 25 degrees. The standard conditions may mean conditions that are criterions for evaluating experiment data. For example, in FIG. 4, standard conditions are shown, including a temperature of 25 degrees, a charge current and a discharge current of 1/3 C, and an SOC between 0 % and 100 %.

The controller 120 may determine target experiment data 401 corresponding to the standard conditions as standard data and determine a score of the standard data to be 50 points. As shown in FIG. 4, the controller 120 may determine 100 points as a score for target experiment data that is twice or more the cycle value of the standard data.

For example, in the embodiment of FIG. 4, the cycle value of the standard data is assumed to be 667.70. A value twice the cycle value of the standard data is 1335.4. Thus, the score of the target experiment data having a cycle value of 1335.4 or more may be determined to be 100 points.

Referring back to FIG. 2, the controller 120 may calculate a stress score for a battery by calculating a matching probability corresponding to a score for each of a plurality of target experiment data. Depending on an embodiment, the controller 120 may calculate a stress score by summing all values obtained by multiplying a score of each target experiment data by a matching probability for each of a plurality of target experiment data.

Depending on an embodiment, the controller 120 may classify target experiment data having a matching probability equal to or greater than a threshold value among the plurality of target experiment data as a first group, and calculate a stress score by summing a product of a score corresponding to each target data included in the first group and a corresponding matching probability.

According to an embodiment, the controller 120 may interpolate a matching probability value of the target data or adjust a threshold value for the matching probability, when the number of target experiment data included in the first group is less than the threshold value.

Depending on an embodiment, the controller 120 may classify target experiment data having an area-specific similarity equal to or greater than a threshold value as a second group, and calculate a stress score by summing a product of a score corresponding to each target experiment data included in the second group and a corresponding matching probability.

According to an embodiment, the controller 120 may interpolate an area-specific similarity value of the target data or adjust a threshold value for the similarity value, when the number of target experiment data included in the second group is less than the threshold value.

Depending on an embodiment, the controller 120 may calculate the stress score for the first group as a first stress score and the stress score for the second group as a second stress score and provide them to the user.

By separately calculating and providing the stress scores for various groups, the controller 120 may satisfy various needs of the user.

Meanwhile, the controller 120 may selectively include a processor, an application-specific integrated circuit (ASIC), other chipsets, a logic circuit, a register, a communication modem, a data processing device, etc., known in this field to execute various control logics performed herein. Thus, when the control logic is implemented as software, the controller 120 may be implemented as a group of program modules. In this case, the program module may be stored in a memory and may be executed by the controller 120. The memory may be inside or outside the controller 120 and may be connected to the controller by well-known various means.

Moreover, the battery management apparatus 100 may further include a storage unit (not shown). The storage unit may store data or a program required for each component of the battery management apparatus 100 to perform an operation and a function of each component or data, etc., generated in a process of performing the operation and the function. The storage unit may not be specially limited to a specific type as long as it is a well-known information storage means known to record, erase, update, and read data. As an example, the information storage means may include RAM, flash memory, ROM, EEPROM, register, etc. In addition, the storage unit may store program codes where processes executable by the controller 120 are defined.

For example, the storage unit may include a plurality of experiment data and information related thereto. The controller 120 may access the storage unit to obtain the plurality of experiment data and the experiment condition-specific table.

The controller 120 may be configured to determine a probability of match between a plurality of previously obtained target experiment data and a data distribution.

Herein, the target experiment data may be experiment data selected by the controller 120 among the plurality of experiment data. Depending on an embodiment, the controller 120 may determine a type of information based on whether the obtained information of the battery is during-driving information or during-charge information. The controller 120 may determine at least one data corresponding to the determined type among the plurality of previously obtained experiment data as the target experiment data.

For example, when the obtained information of the battery is determined to be the during-driving information as the type of the information, the controller 120 may determine, as target data, only experimental data with the during-driving information as the type of the information among the plurality of previously obtained experiment data.

The controller 120 may score the matching probability for the during-driving information type and the matching probability for the during-charge information type, respectively. The controller 120 may calculate a stress score for the battery by integrating scores related to the during-driving and during-charge information types.

That is, the battery management apparatus 100 may calculate a stress score for the battery based on the state of the battery (charge or discharge (driving of the vehicle)). Thus, the stress score calculated by the battery management apparatus 100 may more accurately reflect the current lifetime state of the battery.

The controller 120 may generate a response message including the stress score when receiving a request message for the stress score. The controller 120 may output the generated response message.

Depending on an embodiment, the controller 120 may generate a response message further including a driving guide corresponding to the stress score. The driving guide may mean a guide for a driving habit and/or a charge habit. Depending on an embodiment, the controller 120 may determine the driving guide to be included in the response message among one or more previously stored driving guides.

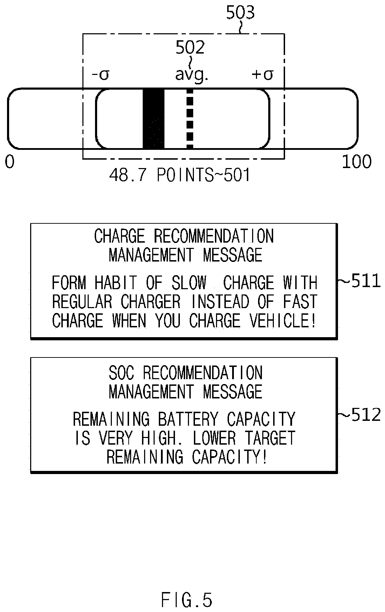

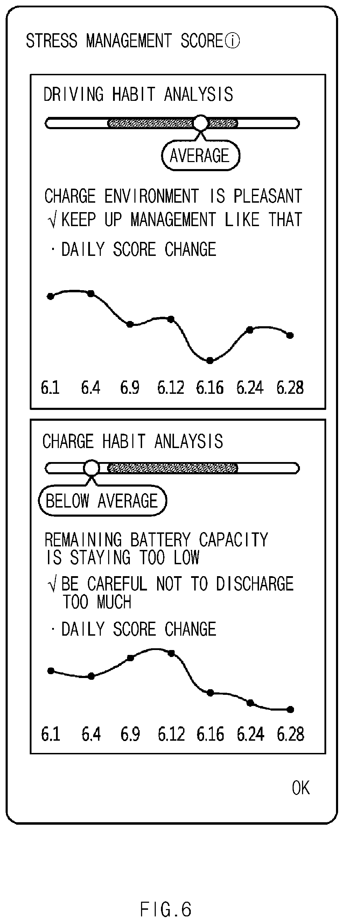

Depending on an embodiment, the controller 120 may determine the driving guide based on the stress score and/or the data included in the obtained battery information. For example, the controller 120 may calculate a value for temperature, charge current, discharge current, and/or SOC based on the data included in the obtained battery information and determine the driving guide based on the calculated result value and the stress score. This will be described in detail with reference to FIGS. 5 and 6.

FIG. 5 is a view for describing a response message referred in various embodiments disclosed herein. In FIG. 5, an example of a response message including a stress score and a driving guide is shown.

The controller 120 may display a calculated stress score 501 and display an average stress score avg 502 of the battery together. The controller 120 may display and propose a target stress score section 503 based on the average stress score.

The controller 120 may calculate a value for temperature, charge current, discharge current, and/or SOC based on the data included in the obtained battery information and determine the driving guide based on the calculated result value and the stress score.

In FIG. 5, as an example of the driving guide, a charge recommendation management message 511 and an SOC recommendation management message 512 are shown.

FIG. 6 is another view for describing a response message referred in various embodiments disclosed herein. In FIG. 6, an example of a detailed message regarding a stress score is shown.

Depending on an embodiment, the controller 120 may output a detailed page together with a stress score through a response message, when receiving a request for the stress score.

Depending on an embodiment, the controller 120 may output the response message including the stress score when receiving the request for the stress score and output the detailed message when receiving an additional input for the stress score included in the output response message.

As shown in FIG. 6, the detailed message may include detailed information about analysis of a driving habit and a charge habit according to the stress score.

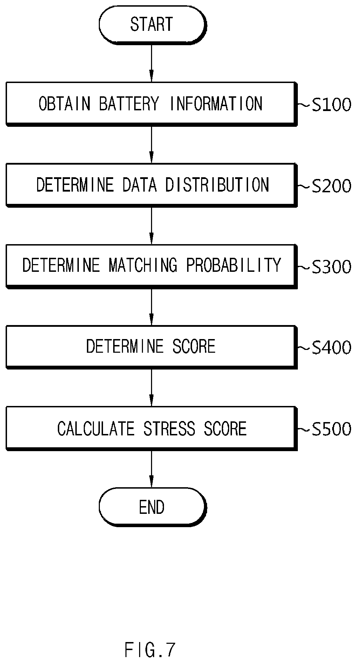

Hereinbelow, a battery management method will be described in detail with reference to FIG. 7.

FIG. 7 is a diagram schematically showing a battery management method according to an embodiment disclosed herein.

Preferably, each operation of the battery management method may be performed by the battery management apparatus 100. Hereinbelow, a matter redundant to the foregoing matter described will be omitted or briefly described.

Referring to FIG. 7, a battery management method according to an embodiment disclosed herein may include operation S100 of obtaining battery information, operation S200 of determining a data distribution, operation S300 of determining a matching probability, operation S400 of determining a score, and operation S500 of calculating a stress score.

Hereinbelow, operations S100 through S500 will be described in detail with reference to FIGS. 1 and 2.

Operation S100 may be an operation of obtaining battery information of at least one of voltage, current, and temperature and may be performed by the data obtaining unit 110.

In operation S100, the data obtaining unit 110 may obtain information related to a battery for which a stress score is to be calculated. According to an embodiment, the data obtaining unit 110 may obtain, from the BMS 50, the information related to the battery for which a stress score is to be calculated.

The data obtaining unit 110 may obtain information about the battery from the BMS 50 in real time or according to a predetermined period. Alternatively, the data obtaining unit 110 may obtain the information when a preset event occurs. The present disclosure is not limited thereto.

When data is not obtained from the BMS 50, the data obtaining unit 110 may transmit a request for providing data to the BMS 50 or the user terminal 30.

Operation S200 is an operation of determining a data distribution of the battery based on the battery information obtained in operation S 100, and may be performed by the controller 120.

In operation S200, the controller 120 may determine the data distribution of the battery based on obtained battery information. Depending on an embodiment, the controller 120 may determine a type of information based on whether the obtained information of the battery is during-driving information or during-charge information. The controller 120 may determine at least one data corresponding to the determined type among the plurality of previously obtained experiment data as the target experiment data. For example, when the obtained information of the battery is determined to be the during-driving information as the type of the information, the controller 120 may determine, as target data, experimental data with the during-driving information as the type of the information among the plurality of previously obtained experiment data.

As the controller 120 determines the target experiment data based on the type of the information, the accuracy of calculation of the stress score may be improved.

According to an embodiment, the controller 120 may determine the data distribution of the battery by calculating an area-specific frequency for the battery information. The area-specific frequency may mean a frequency of each of areas included in the battery information. For example, when the battery information includes information about voltage, current, and temperature, the area-specific frequency may mean a frequency for each of a voltage area, a current area, and a temperature area.

Operation S300 is an operation of determining a matching probability between a plurality of previously obtained target experiment data and a data distribution, and may be performed by the controller 120.

In operation S300, the controller 120 may determine the match probability for each of the plurality of target experiment data, based on the area-specific frequency of the battery information and the area-specific frequency of each of the plurality of target experiment data.

According to an embodiment, the controller 120 may determine, for each area, a similarity between a frequency of each experiment data with respect to a sum of frequencies of a plurality of target experiment data, and a frequency for battery information, and determine a matching probability based on the similarity.

Depending on an embodiment, the controller 120 may sum one or more similarities calculated respectively for the plurality of target experiment data to determine the matching probability corresponding to each of the plurality of target experiment data.

Operation S400 is an operation of determining a score for each of the plurality of target experiment data based on the battery information and may be performed by the controller 120.

In operation S400, the controller 120 may determine a score for each of the plurality of target experiment data based on the obtained battery information. Depending on an embodiment, the controller 120 may determine a score for each of the plurality of target experiment data based on a preset experiment condition-specific table. The preset experiment condition-specific table may mean result data of a battery deterioration experiment performed in an environment limited by a specific condition. For example, the experiment condition-specific table may mean a table regarding target experiment data corresponding to a battery deterioration experiment performed by adding a condition to at least one area among a temperature, a charge current, a discharge current, a minimum SOC, and a maximum SOC of a battery and a SOH with respect to the number of times of charge/discharge of the target experiment data.

Depending on an embodiment, the controller 120 may generate a SOH profile according to a cycle by processing data obtained by a battery deterioration experiment performed in the limited environment.

The cycle may mean a value obtained by considering charge/discharge of the battery as one period. For example, 1 cycle may mean that the battery is charged and discharged once based on an SOC of 0 % and an SOC of 100 %.

Depending on an embodiment, the controller 120 may determine a score for the number of times of charge/discharge in which a calculated SOH reaches a threshold value. The threshold value may be a set value corresponding to the battery or a user-set value.

Depending on an embodiment, the controller 120 may input a cycle value corresponding to a point in which a SOH is a threshold value for each of a plurality of target experiment data, to an experiment condition-specific table. The controller 120 may determine a score for each of the plurality of target experiment data based on the input cycle.

Depending on an embodiment, the controller 120 may determine a score by interpolating a value for each of the plurality of target experiment data based on standard conditions. The standard conditions may mean conditions that are criterions for evaluating experiment data.

Operation S500 is an operation of calculating the stress score for the battery by calculating a score for each of the plurality of target experiment data and a corresponding matching probability and may be performed by the controller 120.

In operation S500, the controller 120 may calculate the stress score for the battery by calculating a matching probability corresponding to the score for each of the plurality of target experiment data.

Depending on an embodiment, the controller 120 may calculate a stress score by summing all values obtained by multiplying a score of each target experiment data by a matching probability for each of a plurality of target experiment data.

Depending on an embodiment, the controller 120 may classify target experiment data having a matching probability equal to or greater than a threshold value among the plurality of target experiment data as a first group, and calculate a stress score by summing a product of a score corresponding to each target data included in the first group and a corresponding matching probability.

According to an embodiment, the controller 120 may interpolate a matching probability value of the target data or adjust a threshold value for the matching probability, when the number of target experiment data included in the first group is less than the threshold value.

Depending on an embodiment, the controller 120 may classify target experiment data having an area-specific similarity equal to or greater than a threshold value as a second group, and calculate a stress score by summing a product of a score corresponding to each target experiment data included in the second group and a corresponding matching probability.

According to an embodiment, the controller 120 may interpolate an area-specific similarity value of the target data or adjust a threshold value for the similarity value, when the number of target experiment data included in the second group is less than the threshold value.

Depending on an embodiment, the controller 120 may calculate the stress score for the first group as a first stress score and the stress score for the second group as a second stress score and provide them to the user.

By separately calculating and providing the stress scores for various groups, the controller 120 may satisfy various needs of the user.

The battery management apparatus 100 according to the present disclosure may be included in a battery pack 1000. That is, the battery pack according to the present disclosure may include the above-described battery management apparatus 100 and one or more battery cells. The battery pack may further include an electrical component (a relay, a fuse, etc.), a case, and so forth.

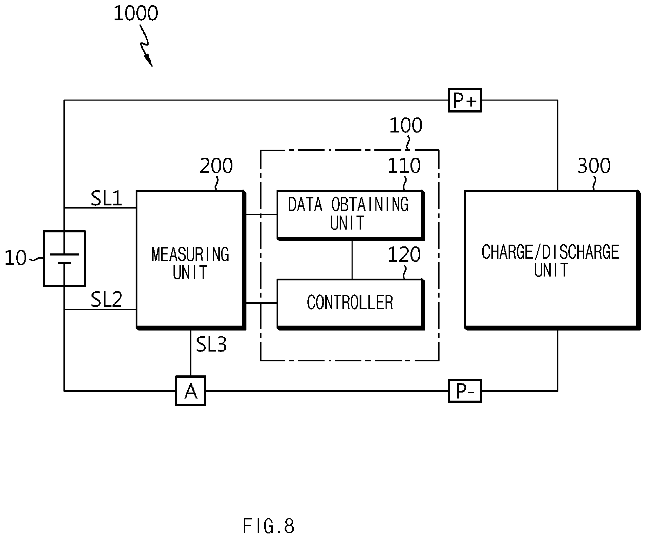

FIG. 8 is a view showing an example configuration of a battery pack including a battery management apparatus according to an embodiment disclosed herein. A positive terminal of the battery 10 may be connected to a positive terminal P+ of the battery pack 1000, and a negative terminal of the battery 10 may be connected to a negative terminal P- of the battery pack 1000.

A measuring unit 200 may be connected to a first sensing line SL1, a second sensing line SL2, and a third sensing line SL3. More specifically, the measuring unit 20 may be connected to the positive terminal of the battery 10 through the first sensing line SL1 and to the negative terminal of the battery 10 through the second sensing line SL2. The measuring unit 20 may measure a voltage of the battery 10 based on a voltage measured in each of the first sensing line SL1 and the second sensing line SL2.

The measuring unit 200 may be connected to a current measuring unit A through the third sensing line SL3. For example, the current measuring unit A may be an ammeter or a shunt resistor capable of measuring a charge current and a discharge current of the battery 10. The measuring unit 20 may measure a charge current of the battery 10 through the third sensing line SL3 to calculate the amount of charge. The measuring unit 200 may also measure the discharge current of the battery 10 through the third sensing line SL3 to calculate the amount of discharge.

A terminal of a load 2 may be connected to the positive terminal P+ of the battery pack 1000, and the other end thereof may be connected to the negative terminal of the battery 1000. Thus, the positive terminal of the battery 10, the positive terminal P+ of the battery pack 1000, the load 2, the negative terminal P- of the battery pack 1000, and the negative terminal of the battery 10 may be electrically connected.

For example, the load 2 may be a charge/discharge device, and may be a motor of an electric vehicle provided with a power from the battery 10, etc.

The data obtaining unit 110 may obtain battery information of at least one of voltage, current, and temperature from the measuring unit 200.

The embodiments of the present disclosure described above are not implemented only through apparatuses and methods, and may be implemented through a program that realizes functions corresponding to the configuration of the embodiments of the present disclosure or a recording medium on which the program is recorded, and such implementation may be easily achieved from the description of the above-described embodiments by an expert in the technical field to which the present disclosure pertains.

Although the present disclosure has been described above with limited embodiments and drawings, the present disclosure is not limited thereto and various modifications and changes may be made by those of ordinary skill in the art within a range equivalent to the technical spirit of the present disclosure and the claims described below.

Moreover, various substitutions, modifications, and changes may be made by those of ordinary skill in the art to the above-described disclosure without departing the technical spirit of the present disclosure, and thus the present disclosure is not limited by the above-described embodiments and the attached drawings, but all or some of the embodiments may be selectively combined to make various modifications.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

## Claims

1. A battery management apparatus comprising:
a data obtaining unit configured to obtain battery information of at least one of voltage, current, and temperature; and
a controller configured to: determine a data distribution of the battery based on the obtained battery information, determine a matching probability between a plurality of previously obtained target experiment data and the data distribution, determine a score for each of the plurality of target experiment data based on the battery information, and calculate the matching probability corresponding to the score for each of the plurality of target experiment data to calculate a stress score for the battery.

2. The battery management apparatus of claim 1, wherein the controller is further configured to:
determine a type based on whether the obtained battery information is during-driving information or during-charge information, and
determine the plurality of target experiment data corresponding to the determined type from among a plurality of previously stored experiment data.

3. The battery management apparatus of claim 1, wherein the controller is further configured to determine the data distribution of the battery by calculating an area-specific frequency for the battery information.

4. The battery management apparatus of claim 3, wherein the controller is further configured to determine the matching probability for each of the plurality of target experiment data based on the area-specific frequency for the battery information and an area-specific frequency for each of the plurality of target experiment data.

5. The battery management apparatus of claim 4, wherein the controller is further configured to determine the matching probability based on a similarity between a frequency of each target experiment data and the area-specific frequency for the battery information with respect to a sum of area-specific frequencies of the plurality of target experiment data for each area.

6. The battery management apparatus of claim 5, wherein the controller is further configured to sum one or more similarities calculated respectively for the plurality of target experiment data to determine the matching probability corresponding to each of the plurality of target experiment data.

7. The battery management apparatus of claim 1, wherein the controller is further configured to determine the score based on a preset experiment condition-specific table for each of the plurality of target experiment data.

8. The battery management apparatus of claim 7, wherein the experiment condition-specific table is preset for experiment conditions including at least one of an experiment temperature, a charge current, a discharge current, a maximum SOC and a minimum SOC, and a SOH corresponding to a number of times of charge/discharge of the target experiment data, and
the controller is further configured to determine the score for a number of times of charge/discharge in which a calculated SOH reaches a threshold value.

9. The battery management apparatus of claim 1, wherein the controller is further configured to generate a response message comprising the stress score and output the generated response message, when receiving a request message for the stress score.

10. The battery management apparatus of claim 9, wherein the controller is further configured to further include at least one of a driving guide and a charge guide corresponding to the stress score in the response message.

11. A battery pack comprising a battery management apparatus according to any one of claims 1 to 10.

12. A server comprising a battery management apparatus according to any one of claims 1 to 10.

13. A battery management method comprising:
obtaining battery information of at least one of voltage, current, and temperature;
determining a data distribution of a battery based on the obtained battery information;
determining a matching probability between a plurality of previously obtained target experiment data and the data distribution;
determining a score for each of the plurality of target experiment data based on the battery information; and
calculating a stress score for the battery by calculating the score for each of the plurality of target experiment data and the corresponding matching probability.
